# EUROPEAN PATENT APPLICATION

(11) **EP 4 216 283 A1**
(43) Date of publication of application: **26.07.2023**
(21) Application number: 22847108.2
(22) Date of filing: 28.07.2022
(51) Int. Cl.: H01L 31/0224, H01L 31/054, H01L 31/0747, H01L 31/18, H01L 31/20

(54) **SOLAR CELL AND PREPARATION METHOD THEREFOR**

(30) Priority: 11.12.2021 CN 202111512883
(71) Applicant: Zhongwei New Energy (Chengdu) Co., Ltd., Chengdu, Sichuan 610225 (CN)
(72) Inventor: ZHANG, Haichuan, Chengdu, Sichuan 610299 (CN); SHI, Jianhua, Chengdu, Sichuan 610299 (CN); MENG, Chuncai, Chengdu, Sichuan 610299 (CN); YUAN, Qiang, Chengdu, Sichuan 610299 (CN); FU, Haoxin, Chengdu, Sichuan 610299 (CN); DU, Junlin, Chengdu, Sichuan 610299 (CN); MENG, Fanying, Chengdu, Sichuan 610299 (CN); LIU, Zhengxin, Chengdu, Sichuan 610299 (CN)
(74) Representative: Marks & Clerk LLP
(86) International application number: PCT/CN2022/108594
(87) International publication number: WO 2023/103409

(57) **Abstract**

A solar cell is provided, includes: a substrate, a first passivation layer, an emission layer, a first conductive layer, a second passivation layer, a back surface field layer and a second conductive layer. The first passivation layer, the emission layer and the first conductive layer are sequentially disposed on a surface of one side of the substrate, and the second passivation layer, the back surface field layer and the second conductive layer are sequentially disposed on a surface of another side of the substrate. The first conductive layer includes a first transparent conductive oxide layer, a first conductive metal layer and a second transparent conductive oxide layer which are sequentially stacked.

## Description

### CROSS REFERENCE TO RELATED APPLICATIONS

This application claims priority to Chinese Patent Application No. 2021115128830, filed with CNIPA on December 11, 2021, entitled "SOLAR CELL AND MANUFACTURING METHOD THEREOF", the entire content of which is incorporated herein in its entirety.

### TECHNICAL FIELD

The present application relates to the technical field of semiconductor devices, and more particularly relates to a solar cell and a manufacturing method thereof.

### BACKGROUND

Energy is fundamental to the development of human society, yet with the development of technology, global demands for energy have been increasing, which gradually make limitation of conventional energy and perniciousness to the environment prominent. In order to resolve environmental pollution problem, energy crisis problem and the likes generated from the developmental process, new energy, especially solar energy, has thus become a class of research. Due to its inexhaustible characteristic and pollution-free advantage, solar energy has received much attention. At present, crystalline silicon cell still occupies a major part of the solar cell market. Since it requires many complicated technics during the preparation process of crystalline silicon cell in order to obtain high conversion rate, the cost is hard to be further reduced.

Therefore, a cost-effective solar cell has always been sought after. To satisfy the need of cost-effective photovoltaic cells, amorphous silicon thin-film solar cell has been created in response to the requirement, where its cost has been greatly reduced compared to that of crystalline silicon cell. Although amorphous silicon thin-film solar cell can be prepared using low-temperature technic and the preparation technic is simple, resulting in low cost and suitability for large-area production, severe Staebler-Wronski effect impacts stability of the cell performance in addition to relatively low cell conversion efficiency, which limits the development thereof. To maintain high conversion efficiency while achieving a reduced cost, heterojunction solar cell that uses amorphous silicon thin-film/monocrystalline silicon substrate with a heterojunction structure has garnered great interests, which inherits the advantages of monocrystalline silicon solar cell and amorphous silicon solar cell, such as good stability, high conversion efficiency, inexpensive cost, low-temperature technic and the likes. The referred stability includes light stability and temperature stability. Specifically, good light stability refers to that the Staebler-Wronski effect on the heterojunction solar cell is weak or even non-existing; good temperature stability refers to that the heterojunction solar cell is even better than the crystalline silicon cell in many aspects including temperature-related parameters, making the heterojunction solar cell good at outputting under the condition of a rising light temperature.

Further, when the heterojunction solar cell is thinned for cost reduction, light transmission loss increases when light of a solar spectrum transmits through the cell, leading to sharp decrease in short-circuit current thereof. When the thickness of silicon wafer is 150µm, heterojunction solar cell may subject to a transmission loss starting from the 950 nm wave band. If the thickness of silicon wafer is further thinned, transmission loss from the solar spectrum starts to occur in a shorter wave band (800nm or 700nm), resulting in continued increase of sunlight losses, which further reduces the efficiency of heterojunction solar cell.

### SUMMARY

According to some embodiments of the present disclosure, a solar cell, including: a substrate, a first passivation layer, an emission layer, a first conductive layer, a second passivation layer, a back surface field layer and a second conductive layer.

The first passivation layer, the emission layer and the first conductive layer are sequentially stacked on a surface of one side of the substrate, and the second passivation layer, the back surface field layer and the second conductive layer are sequentially stacked on a surface of another side of the substrate.

The first conductive layer comprises a first transparent conductive oxide layer, a first conductive metal layer and a second transparent conductive oxide layer which are sequentially stacked.

According to some embodiments of the present disclosure, material of the first transparent conductive oxide layer is selected from at least one of aluminum-doped zinc oxide, gallium and aluminum co-doped zinc oxide, fluorine-doped tin oxide, indium-tin oxide, or titanium-doped indium oxide.

According to some embodiments of the present disclosure, material of the second transparent conductive oxide layer is selected from at least one of aluminum-doped zinc oxide, gallium and aluminum co-doped zinc oxide, fluorine-doped tin oxide, indium-tin oxide, or titanium-doped indium oxide.

According to some embodiments of the present disclosure, material of the second conductive layer is selected from at least one of aluminum-doped zinc oxide, gallium and aluminum co-doped zinc oxide, fluorine-doped tin oxide, indium-tin oxide, or titanium-doped indium oxide.

According to some embodiments of the present disclosure, material of the first conductive metal layer is selected from at least one of copper, silver, magnesium, or aluminum.

According to some embodiments of the present disclosure, a conductivity type of the back surface field layer is N-type or P-type, a conductivity type of the substrate is identical to the conductivity type of the back surface field layer, and a conductivity type of the emission layer is opposite to the conductivity type of the back surface field layer.

According to some embodiments of the present disclosure, a material of the first passivation layer is selected from at least one of intrinsic amorphous silicon or intrinsic microcrystalline silicon.

According to some embodiments of the present disclosure, material of the second passivation layer is selected from at least one of intrinsic amorphous silicon or intrinsic microcrystalline silicon.

According to some embodiments of the present disclosure, the solar cell further includes a first electrode and a second electrode, the first electrode is disposed on the first conductive layer, and the second electrode is disposed on the second conductive layer.

According to some embodiments of the present disclosure, a solar cell preparation method is provided, which includes the following steps:
a. sequentially preparing a first passivation layer, an emission layer, a first transparent conductive oxide layer, a first conductive metal layer and a second transparent conductive oxide layer on a surface of one side of a substrate;
b. sequentially preparing a second passivation layer, a back surface field layer and a second conductive layer on a surface of another side of the substrate.

According to some embodiments of the present disclosure, material of the first transparent conductive oxide layer is selected from at least one of aluminum-doped zinc oxide, gallium and aluminum co-doped zinc oxide, fluorine-doped tin oxide, indium-tin oxide, or titanium-doped indium oxide.

According to some embodiments of the present disclosure, material of the second transparent conductive oxide layer is selected from at least one of aluminum-doped zinc oxide, gallium and aluminum co-doped zinc oxide, fluorine-doped tin oxide, indium-tin oxide, or titanium-doped indium oxide.

According to some embodiments of the present disclosure, material of the second conductive layer is selected from at least one of aluminum-doped zinc oxide, gallium and aluminum co-doped zinc oxide, fluorine-doped tin oxide, indium-tin oxide, or titanium-doped indium oxide.

According to some embodiments of the present disclosure, material of the first conductive metal layer is selected from at least one of copper, silver, magnesium, or aluminum.

According to some embodiments of the present disclosure, a conductivity type of the back surface field layer is N-type or P-type, a conductivity type of the substrate is identical to the conductivity type of the back surface field layer, and conductivity type of the emission layer is opposite to the conductivity type of the back surface field layer.

According to some embodiments of the present disclosure, material of the first passivation layer is selected from at least one of intrinsic amorphous silicon or intrinsic microcrystalline silicon.

According to some embodiments of the present disclosure, material of the second passivation layer is selected from at least one of intrinsic amorphous silicon or intrinsic microcrystalline silicon.

According to some embodiments of the present disclosure, ways of preparing the first passivation layer, the emission layer, the first transparent conductive oxide layer, the first conductive metal layer, the second transparent conductive oxide layer, the second passivation layer, the back surface field layer and the second conductive layer are respectively and independently selected from one of chemical vapor deposition and physical vapor deposition.

According to some embodiments of the present disclosure, the process of preparing the first passivation layer, the emission layer, the first transparent conductive oxide layer, the first conductive metal layer, the second transparent conductive oxide layer, the second passivation layer, the back surface field layer and the second conductive layer are prepared under a temperature that ranges from 130°C to 250°C and an air pressure that ranges from 0.1Pa to 100Pa.

According to some embodiments of the present disclosure, a step of texture processing on the substrate prior to step a is further included.

According to some embodiments of the present disclosure, a step of preparing the first electrode on the second transparent conductive oxide layer after step b is further included.

According to some embodiments of the present disclosure, a way of preparing the first electrode is selected from screen printing, vapor deposition, magnetron sputtering and inkjet printing.

According to some embodiments of the present disclosure, a step of preparing a second electrode on the second conductive layer after step b is further included.

According to some embodiments of the present disclosure, a way of preparing the second electrode is selected from silk-screen printing, vapor deposition, magnetron sputtering and inkjet printing.

Details of one or more embodiments of the present invention are illustrated by the following drawings and descriptions. Other characteristics, objectives and benefits become obvious from the specifications, drawings and claims of the present invention.

### BRIEF DESCRIPTION OF THE DRAWINGS

To better describe and illustrate embodiments and/or examples of the present application, references can be made to one or more drawings. Additional details or examples used to describe the drawings should not be construed as limiting the scope of any of the invention, the presently described embodiments and/or examples, and the presently understood best modes of the invention.

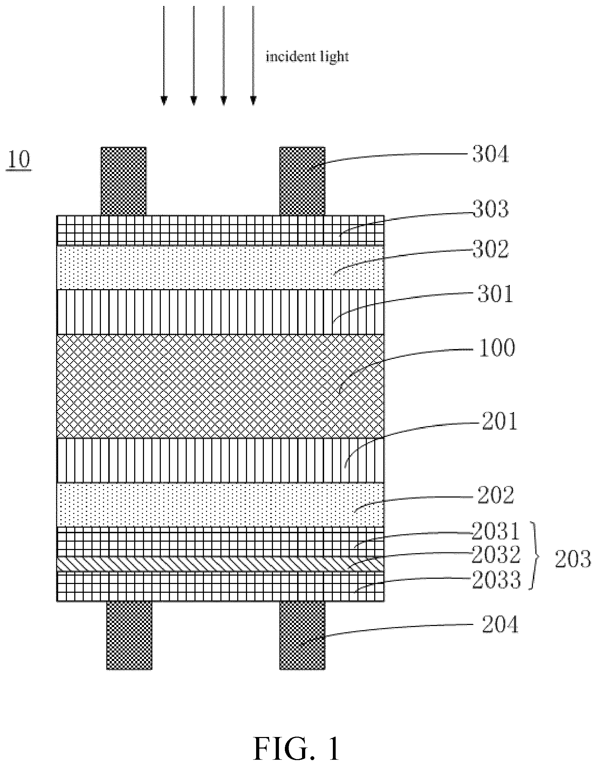

FIG. 1 is a schematic structure diagram of a solar cell according to some embodiments.

Descriptions of reference numerals are as follows:
10: solar cell; 100: substrate; 201: first passivation layer; 202: emission layer; 203: first conductive layer; 2031: first transparent conductive oxide layer; 2032: first conductive metal layer; 2033: second transparent conductive oxide layer; 204: first electrode; 301: second passivation layer; 302: back surface field layer; 303: second conductive layer; 304: second electrode.

### DETAILED DESCRIPTION OF THE EMBODIMENTS

In order to facilitate the understanding of the application, the application is described more comprehensively below with reference to the accompanying drawings. The drawings show preferred embodiments of the application. However, the application may be implemented in various forms and is not limited to the embodiments described herein. It needs to be understood that these embodiments are provided to allow the contents disclosed in the application to be understood more thoroughly and comprehensively.

In addition, the terms such as "first" and "second" are used only for the purpose of description, and should not be understood as indicating or implying the relative importance or implicitly specifying the number or order of the indicated technical features. Therefore, when a features is defined by "first" or "second", at least one such feature can be explicitly or implicitly included. In the description of the present application, unless otherwise particularly defined, "multiple" means at least two, for example, two or three.

As to description of the positional relationships, unless otherwise specified, when an element such as a layer, a film or a substrate is referred to as being "on" another layer or film, it may be directly on another layer or film, or an intermediate layer or film may exist therebetween. Further, when a layer is referred to as being "under" another layer, it may be directly under another layer, or one or more intermediate layers may exist therebetween. It may be also understood that when a layer is referred to as being "between" two layers, the layer may be the only layer between the two layers, or there may also exist one or more intermediate layers other than the layer.

Unless mentioned to the contrary, a term in a singular manner may include a plural form, and should not be construed that the quantity of such term is only one.

Unless otherwise defined, all technical and scientific terms used herein have the same meaning as those normally understood by a person of skill in the art of this application. The terms used herein are for the purpose of describing specific embodiments of the present application rather than limiting the present application.

As shown in FIG 1, a solar cell is provided by an embodiment of the present application, which includes: a substrate 100, a first passivation layer 201, an emission layer 202 and a first conductive layer 203 which are sequentially stacked on a surface of one side of the substrate 100, and a second passivation layer 301, a back surface field layer 302 and a second conductive layer 303 which are sequentially stacked on a surface of another side of the substrate 100.

The first conductive layer 203 includes a first transparent conductive oxide layer 2031, a first conductive metal layer 2032 and a second transparent conductive oxide layer 2033 which are sequentially stacked.

It is to be understood that conductivity of the first conductive layer ranges from 500S/cm to 10000S/cm.

The substrate 100 includes two sides. One side where the second passivation layer 301, the back surface field layer 302, the second conductive layer 303 and a second electrode 304 are disposed refers to a side that receives solar energy, and the other side refers to an opposing side of the side that receives solar energy.

Further, a thickness of the first transparent conductive oxide layer 2031 ranges from 20nm to 50nm, a thickness of the first conductive metal layer 2032 ranges from 5nm to15nm, a thickness of the second transparent conductive oxide layer 2033 ranges from 20nm to 40nm.

It is to be understood that material of substrate 100 may be but is not limited to at least one of monocrystalline silicon or polycrystalline silicon, and is preferably monocrystalline silicon.

Further, a thickness of the substrate 100 ranges from 70µm to 180µm.

In a specific example, material of the second conductive layer 303, material of the first transparent conductive oxide layer 2031 and material of the second transparent conductive oxide layer 2033 are respectively and independently selected from at least one of Aluminum-doped Zinc Oxide (AZO), Gallium and Aluminum co-doped Zinc Oxide (GAZO), Fluorine-doped Tin Oxide (FTO), Indium-Tin Oxide (ITO), or Titanium-doped Indium Oxide (ITIO).

Further, a thickness of the second conductive layer ranges from 65nm to 100nm.

In a specific example, material of the first conductive metal layer 2032 is selected from at least one of copper, silver, magnesium or aluminum.

In a specific example, the back surface field layer 302 has a first conductivity type, the substrate 100 has the first conductivity type, the emission layer 202 has a second conductivity type, where the first conductivity type is contrary to the second conductivity type.

It may be understood that: when the substrate 100 is N-type, the back surface field layer 302 is N-type and the emission layer 202 is P-type; when the substrate 100 is P-type, the back surface field layer 302 is P-type and the emission layer 202 is N-type.

Further, a thickness of the emission layer ranges from 8nm to 20nm, and a thickness of the back surface field layer ranges from 5nm to 15nm.

It may be understood that material of the emission layer and material of the back surface field layer may be but are not limited to using at least one of intrinsic amorphous silicon or microcrystalline silicon as a base material that is being doped, and a doping material may be but is not limited to B₂H₆ and PH₃. It may be understood that a doping density of the doping material in the base material ranges from 1% to 3%.

In a specific example, material of the first passivation layer 201 and material of the second passivation layer 301 are respectively and independently selected from at least one of intrinsic amorphous silicon or microcrystalline silicon.

Further, a thickness of the first passivation layer ranges from 5nm to 20nm, and a thickness of the second passivation layer ranges from 5nm to 20nm.

In a specific example, the solar cell also includes a first electrode 204 disposed on the first conductive layer 203, and a second electrode 304 disposed on the second conductive layer 303.

It may be understood that material of the first electrode 204 and material of the second electrode 304 are respectively and independently selected from at least one of gold and silver. Further, the quantity and position of each of the first electrode 204 and the second electrode 304 are not limited by the illustration of FIG. 1, and may be designed according to actual needs.

Further, a thickness of the first electrode 204 ranges from 2µm to 50µm, and a thickness of the second electrode 304 ranges from 2µm to 50µm.

The first conductive layer in the solar cell adopts a structure which sequentially stacks the first transparent conductive oxide layer, the first conductive metal layer and the second transparent conductive oxide layer. Such a sandwich structure can effectively reflect sunlight which penetrates through the substrate to reach a transparent electrode on the back, thereby improving re-utilization of light by a heterojunction solar cell and further increasing short-circuit current of the heterojunction solar cell. Meanwhile, as the metal layer added into the sandwich structure makes an electrical conductivity of the sandwich structure better than that of a traditional transparent conductive oxide film, it can effectively improve a fill factor of the heterojunction solar cell, which further improves photoelectric conversion efficiency of the heterojunction solar cell. In addition, the sandwich structure may decrease the overall thickness of the transparent conductive oxide film, thereby reducing the consumption of transparent conductive oxide target material, and achieving the goal of cost reduction.

Further, a manufacturing method of solar cell as mentioned above is provided by the present invention, which includes the following steps.

In step S10, a first passivation layer 201, an emission layer 202, a first transparent conductive oxide layer 2031, a first conductive metal layer 2032 and a second transparent conductive oxide layer 2033 are sequentially stacked onto a surface of one side of a substrate 100.

In step S20, a second passivation layer 301, a back surface field layer 302 and a second conductive layer 303 are sequentially stacked onto a surface of another side of the substrate 100.

It may be understood that the step S10 and step S20 may be executed in no particular order, and that the deposition onto one side of the substrate 100 does not have to occur upon completion of deposition onto the other side of the substrate 100. Specifically, deposition onto two sides of the substrate 100 may be performed alternately.

In a specific example, ways of preparing the first passivation layer 201, the emission layer 202, the first transparent conductive oxide layer 2031, the first conductive metal layer 2032, the second transparent conductive oxide layer 2033, the second passivation layer 301, the back surface field layer 302 and the second conductive layer 303 may be respectively and independently selected from at least one of chemical vapor deposition and physical vapor deposition.

It may be understood that the way to prepare the first passivation layer 201, the second passivation layer 301, the emission layer 202 and the back surface field layer 302 is preferably chemical vapor deposition. Chemical vapor deposition may be but is not limited to at least one of plasma enhanced chemical vapor deposition, high density plasma chemical vapor deposition, or catalyzed chemical vapor deposition.

Further, the way to prepare the first transparent conductive oxide layer 2031, the first conductive metal layer 2032, the second transparent conductive oxide layer 2033 and the second conductive layer 303 is preferably physical vapor deposition. Physical vapor deposition may be but is not limited to at least one of radio frequency sputtering, direct current sputtering, or pulsed sputtering.

It should be noted that the first conductive metal layer 2032 may be but is not limited to a metal film or a metal grid.

In a specific example, during preparation, a temperature ranges from 130°C to 250°C, and an air pressure ranges from 0.1Pa to 100Pa.

It may be understood that the air pressure refers to process chamber pressure.

In a particular example, prior to step S10, a step of performing a texture processing on the substrate 100 is also included.

It may be understood that performing texture processing on the substrate 100 may reduce reflection from a surface of the cell, allowing more photons to be absorbed by a crystalline silicon wafer 110. Meanwhile, it may remove damages from the surface of a crystalline silicon. A pyramid-shaped light trapping structure may be formed, thereby benefiting light to emit obliquely into an interior of the substrate 100, reducing a light reflection rate from the surface of the cell, enlarging an optical path, and increasing a quantity of photons absorbed.

Further, after step S20, steps of preparing the first electrode 204 onto the second transparent conductive oxide layer and preparing the second electrode 304 onto the second conductive layer 303 are included. Ways of preparing the first electrode 204 and the second electrode 304 are respectively and independently selected from at least one of screen printing, vapor deposition, magnetron sputtering and ink-jet printing.

Specifically, a preferable way to prepare the first passivation layer 201, the emission layer 202, the second passivation layer 301 and the back surface field 302 is Plasma Enhanced Chemical Vapor Deposition (PECVD).

It may be understood that during the preparation process of the first passivation layer 201 and the second passivation layer, a temperature ranges from 200°C to 250°C, and an air pressure ranges from 50Pa to 90Pa.

During the preparation process of the back surface field layer 302 and the emission layer 202, a temperature ranges from 170°C to 240°C, and an air pressure ranges from 50Pa to 90Pa.

Further, a preferable way to prepare the first transparent conductive oxide layer 2031, the first conductive metal layer 2032 and the second transparent conductive oxide layer 2033 in the first conductive layer 203, and the second conductive layer 203 is magnetron sputtering.

During the preparation process of the first conductive layer 203 and the second conductive layer 203, a temperature ranges from 130°C to 170°C, and an air pressure ranges from 0.1Pa to 10Pa.

The first conductive layer in the solar cell adopts a structure which sequentially stacks the first transparent conductive oxide layer, the first conductive metal layer and the second transparent conductive oxide layer. Such a sandwich structure can effectively reflect sunlight which penetrates through the substrate to reach a transparent electrode on the back, thereby improving re-utilization of light by a heterojunction solar cell and further increasing short-circuit current of the heterojunction solar cell. Meanwhile, as the metal layer added into the sandwich structure makes an electrical conductivity of the sandwich structure better than that of a traditional transparent conductive oxide film, it can effectively improve a fill factor of the heterojunction solar cell, which further improves photoelectric conversion efficiency of the heterojunction solar cell. In addition, the sandwich structure may decrease the overall thickness of the transparent conductive oxide film, thereby reducing the consumption of transparent conductive oxide target material, and achieving the goal of cost reduction.

A solar cell provided by the present invention is further detailed hereinafter in conjunction with specific embodiments.

### Embodiment 1

A solar cell is provided by a present embodiment, which includes a structure that sequentially stacks a 20nm silver grid serving as a first electrode, a 30 nm indium-tin oxide (tin-doped mass percentage 10wt.%) serving as a second transparent conductive oxide layer, a 9nm copper film serving as a first conductive metal layer, a 30 nm indium-tin oxide (tin-doped mass percentage 10wt.%) serving as a first transparent conductive oxide layer, a 12nm B₂H₆-doped amorphous silicon with B₂H₆ doping concentration of 1.5% serving as an emission layer, an 8nm intrinsic amorphous silicon serving as a first passivation layer, a 150µm N-type monocrystalline silicon serving as a substrate, an 8nm intrinsic amorphous silicon serving as a second passivation layer, a 10nm PH₃-doped amorphous silicon with PH₃ doping concentration of 2% serving as a back surface field layer, an 80 nm indium-tin oxide (tin-doped mass percentage 3wt.%) serving as a second conductive layer and a 20nm silver grid serving as a second electrode.

Manufacturing method of the above-mentioned solar cell is as follows.

A mechanically damaged layer on a surface of an N-type monocrystalline silicon substrate is washed to form a clean pyramidal light trapping structure. A first passivation layer and a second passivation layer are respectively prepared on one side of the monocrystalline silicon substrate and on the other side of the monocrystalline silicon substrate, using PECVD at a temperature of 230°C and an air pressure of 70Pa; an emission layer is prepared on the first passivation layer using a PECVD method at a temperature of 180°C and an air pressure of 65Pa. Using a magnetron sputtering method, a first transparent conductive oxide layer is prepared on the emission layer at a temperature of 150°C and an air pressure of 0.4Pa, a first conductive metal layer is prepared on the first transparent conductive oxide layer at a temperature of 150°C and an air pressure of 0.4Pa, and a second transparent conductive oxide layer is prepared on the first conductive metal layer at a temperature of 150°C and an air pressure of 0.4Pa. A back surface field layer is prepared on the second passivation layer using PECVD at a temperature of 220°C and an air pressure of 85Pa, a second conductive layer is prepared on the back surface field layer using a magnetron sputtering method at a temperature of 150°C and an air pressure of 0.35Pa, and lastly a first electrode and a second electrode are respectively prepared on the second transparent conductive oxide layer and on the second conductive layer using screen printing.

### Embodiment 2

A solar cell is provided by a present embodiment, which includes a structure that sequentially stacks a 20nm silver grid serving as a first electrode, a 30 nm indium-tin oxide (tin-doped mass percentage 10wt.%) serving as a second transparent conductive oxide layer, a 12nm copper film serving as a first conductive metal layer, a 40 nm indium-tin oxide (tin-doped mass percentage 10wt.%) serving as a first transparent conductive oxide layer, a 12nm B₂H₆-doped amorphous silicon with B₂H₆ doping concentration of 1.5% serving as an emission layer, an 8nm intrinsic amorphous silicon serving as a first passivation layer, a 130µm N-type monocrystalline silicon serving as a substrate, an 8nm intrinsic amorphous silicon serving as a second passivation layer, a 10nm PH₃-doped amorphous silicon with PH₃ doping concentration of 1.8% serving as a back surface field layer, an 80 nm indium-tin oxide (tin-doped mass percentage 3wt.%) serving as a second conductive layer and a 20nm silver grid serving as a second electrode.

Manufacturing method of the above-mentioned solar cell is as follows.

A mechanically damaged layer on a surface of an N-type monocrystalline silicon substrate is washed to form a clean pyramidal light trapping structure. A first passivation layer and a second passivation layer are respectively prepared on one side of the monocrystalline silicon substrate and on the other side of the monocrystalline silicon substrate, using PECVD at a temperature of 230°C and an air pressure of 80Pa; an emission layer is prepared on the first passivation layer using a PECVD method at a temperature of 180°C and an air pressure of 65Pa. Using a magnetron sputtering method, a first transparent conductive oxide layer is prepared on the emission layer at a temperature of 150°C and an air pressure of 0.4Pa, a first conductive metal layer is prepared on the first transparent conductive oxide layer at a temperature of 150°C and an air pressure of 0.4Pa, and a second transparent conductive oxide layer is prepared on the first conductive metal layer at a temperature of 150°C and an air pressure of 0.4Pa; A back surface field layer is prepared on the second passivation layer using PECVD at a temperature of 220°C and an air pressure of 85Pa, a second conductive layer is prepared on the back surface field layer using a magnetron sputtering method at a temperature of 150°C and an air pressure of 0.45Pa, and lastly a first electrode and a second electrode are respectively prepared on the second transparent conductive oxide layer and on the second conductive layer using screen printing.

Any combinations may be formed by technical features in the embodiments above. In order to make a concise description, not all possible combinations of each technical feature in the above-mentioned embodiments are described. Nevertheless, as long as no contradictions are present for the combinations of the technical features, all combinations should be deemed to fall within the scope of the present specification.

Embodiments above are only a few implementations of the present application, and the descriptions thereof are relatively specific and detailed, yet they should not be construed as limitations on the scope of the present application. It should be noted that, for those of ordinary skills in the art, various modifications and enhancement may be implemented under the premise that the concept of the present application is not departed from, and these modifications and enhancement all fall within the protection scope of the present application. Therefore, protection scope of the present application should be subject to the appended claims, and specification and drawings may be used to interpret the content of the claims.

## Claims

1. A solar cell, comprising:
a substrate, a first passivation layer, an emission layer, a first conductive layer, a second passivation layer, a back surface field layer and a second conductive layer;
wherein the first passivation layer, the emission layer and the first conductive layer are sequentially stacked onto a surface of one side of the substrate, and the second passivation layer, the back surface field layer and the second conductive layer are sequentially stacked onto a surface of another side of the substrate;
wherein the first conductive layer comprises a first transparent conductive oxide layer, a first conductive metal layer and a second transparent conductive oxide layer which are sequentially stacked.

2. The solar cell according to claim 1, wherein a material of the first transparent conductive oxide layer is selected from at least one of aluminum-doped zinc oxide, gallium and aluminum co-doped zinc oxide, fluorine-doped tin oxide, indium-tin oxide, or titanium-doped indium oxide.

3. The solar cell according to claim 1, wherein a material of the second transparent conductive oxide layer is selected from at least one of aluminum-doped zinc oxide, gallium and aluminum co-doped zinc oxide, fluorine-doped tin oxide, indium-tin oxide, or titanium-doped indium oxide.

4. The solar cell according to claim 1, wherein a material of the second conductive layer is selected from at least one of aluminum-doped zinc oxide, gallium and aluminum co-doped zinc oxide, fluorine-doped tin oxide, indium-tin oxide, or titanium-doped indium oxide.

5. The solar cell according to claim 1, wherein a material of the first conductive metal layer is selected from at least one of copper, silver, magnesium, or aluminum.

6. The solar cell according to claim 1, wherein a conductivity type of the back surface field layer is N-type or P-type, a conductivity type of the substrate is identical to the conductivity type of the back surface field layer, and a conductivity type of the emission layer is opposite to the conductivity type of the back surface field layer.

7. The solar cell according to claim 1, wherein a material of the first passivation layer is selected from at least one of intrinsic amorphous silicon or intrinsic microcrystalline silicon.

8. The solar cell according to claim 1, wherein a material of the second passivation layer is selected from at least one of intrinsic amorphous silicon or intrinsic microcrystalline silicon.

9. The solar cell according to any one of claims 1-8, further comprising a first electrode and a second electrode, wherein the first electrode is disposed on the first conductive layer, and the second electrode is disposed on the second conductive layer.

10. A solar cell manufacturing method, comprising:
step a. sequentially preparing a first passivation layer, an emission layer, a first transparent conductive oxide layer, a first conductive metal layer and a second transparent conductive oxide layer on a surface of one side of a substrate;
step b. sequentially preparing a second passivation layer, a back surface field layer and a second conductive layer on a surface of another side of the substrate.

11. The solar cell manufacturing method according to claim 10, wherein a material of the first transparent conductive oxide layer is selected from at least one of aluminum-doped zinc oxide, gallium and aluminum co-doped zinc oxide, fluorine-doped tin oxide, indium-tin oxide, or titanium-doped indium oxide.

12. The solar cell manufacturing method according to claim 10, wherein a material of the second transparent conductive oxide layer is selected from at least one of aluminum-doped zinc oxide, gallium and aluminum co-doped zinc oxide, fluorine-doped tin oxide, indium-tin oxide, or titanium-doped indium oxide.

13. The solar cell manufacturing method according to claim 10, wherein a material of the second conductive layer is selected from at least one of aluminum-doped zinc oxide, gallium and aluminum co-doped zinc oxide, fluorine-doped tin oxide, indium-tin oxide, or titanium-doped indium oxide.

14. The solar cell manufacturing method according to claim 10, wherein a material of the first conductive metal layer is selected from at least one of copper, silver, magnesium, or aluminum.

15. The solar cell manufacturing method according to claim 10, wherein a conductivity type of the back surface field layer is N-type or P-type, a conductivity type of the substrate is identical to the conductivity type of the back surface field layer, and a conductivity type of the emission layer is opposite to the conductivity type of the back surface field layer.

16. The solar cell manufacturing method according to claim 10, wherein a material of the first passivation layer is selected from at least one of intrinsic amorphous silicon or intrinsic microcrystalline silicon.

17. The solar cell manufacturing method according to claim 10, wherein a material of the second passivation layer is selected from at least one of intrinsic amorphous silicon or intrinsic microcrystalline silicon.

18. The solar cell manufacturing method according to claim 10, wherein ways of preparing the first passivation layer, the emission layer, the first transparent conductive oxide layer, the first conductive metal layer, the second transparent conductive oxide layer, the second passivation layer, the back surface field layer and the second conductive layer are respectively and independently selected from one of chemical vapor deposition or physical vapor deposition.

19. The solar cell manufacturing method according to claim 18, wherein the first passivation layer, the emission layer, the first transparent conductive oxide layer, the first conductive metal layer, the second transparent conductive oxide layer, the second passivation layer, the back surface field layer and the second conductive layer are prepared under a temperature that ranges from 130°C to 250°C and an air pressure that ranges from 0.1 Pa to 100Pa.

20. The solar cell manufacturing method according to any one of claims 10-19, further comprising a step of texture processing on the substrate prior to step a.

21. The solar cell manufacturing method according to any one of claims 10-19, further comprising a step of preparing a first electrode on the second transparent conductive oxide layer after step b.

22. The solar cell manufacturing method according to claim 21, wherein a way of preparing the first electrode is selected from screen printing, vapor deposition, magnetron sputtering and ink-jet printing.

23. The solar cell manufacturing method according to any one of claims 10-19, further comprising a step of preparing a second electrode on the second conductive layer after step b.

24. The solar cell manufacturing method according to claim 23, wherein a way of preparing the second electrode is selected from screen printing, vapor deposition, magnetron sputtering and ink-jet printing.
